# EUROPÄISCHE PATENTSCHRIFT

(11) **EP 0 752 176 B1**
(45) Veröffentlichungstag und Bekanntmachung des Hinweises auf die Patenterteilung: **16.06.1999**
(21) Anmeldenummer: 95912204.5
(22) Anmeldetag: 04.03.1995
(51) Int. Cl.: H03M 3/02, B60T 8/00

(54) **SCHALTUNGSANORDNUNG ZUR AUFBEREITUNG UND A/D-WANDLUNG EINES ANALOGEN SIGNALS**
CIRCUIT FOR CONDITIONING AND DIGITISING AN ANALOGUE SIGNAL
CIRCUIT DE CONDITIONNEMENT ET DE NUMERISATION D'UN SIGNAL ANALOGIQUE

(30) Priorität: 22.03.1994 DE 4409708
(43) Veröffentlichungstag der Anmeldung: 08.01.1997
(73) Patentinhaber: Continental Teves AG & Co. oHG, 60488 Frankfurt (DE)
(72) Erfinder: ZYDEK, Michael, D-35428 Langgöns (DE); FEY, Wolfang, D-65227 Niedernhausen (DE); TRASKOV, Adrian, D-61449 Steinbach (DE)
(86) Internationale Anmeldenummer: EP9500805
(87) Internationale Veröffentlichungsnummer: WO9526079

(56) Entgegenhaltungen:
- WO-A-91/06457
- FR-A- 2 532 445
- PROCEEDINGS OF THE EUROPEAN CONFERENCE ON POWER ELECTRONICS AND APPLICATIONS. (EPE), AACHEN, 9 - 12 OCTOBER, 1989, Bd. 1, 9.Oktober 1989 LEONHARD W;HOLTZ J; SKUDELNY H C, Seiten 251-256, XP 000143399 PATNI C K 'INNOVATIVE SINGLE-AXIS DIGITAL-CONTROL SERVO SYSTEMS FOR BRUSH AND BRUSHLESS DC PERMANENT MAGNET MOTORS'

## Beschreibung

Die Erfindung bezieht sich auf eine Schaltungsanordnung zur Aufbereitung und A/D-Wandlung eines analogen Signals, mit einer Triggerschaltung, die das analoge Signal mit einer veränderlichen, sich an das aufzubereitende Signal anpassenden Hysterese verarbeitet. Eine allgemein zur Signalaufbereitung und A/D-Wandlung geeignete Schaltung ist ebenfalls Gegenstand der Erfindung.

Aus der DE 39 36 831 A1 ist bereits eine Schaltungsanordnung zur Aufbereitung des analogen Ausgangssignals eines Drehzahlsensors bekannt, die eine Triggerschaltung umfaßt, deren Umschaltpunkte oder "Hysterese" steuerbar sind. Es wird der Kopplungsfaktor, der multipliziert mit der der Drehzahl entsprechenden Frequenz des Sensorsignals die Amplitude des Sensor-Ausgangssignals ergibt, ermittelt. Die Hysterese der Triggerschaltung wird dann in Abhängigkeit von dem Kopplungsfaktor variiert bzw. dem Kopplungsfaktor angepaßt. Bei hohem Kopplungsfaktor wird die Hysterese hoch, bei geringem Kopplungsfaktor niedrig. Es wird ein relativ hoher Aufwand zur feinstufigen Errechnung der Kopplungsfaktoren in der Anfangsphase einer Drehbewegung und bei steigender Drehwinkelgeschwindigkeit betrieben.

Schaltungsanordnungen dieser Art werden z.B. für die Auswertung der Radsensorsignale benötigt, die in Fahrzeugen mit blockiergeschützten Bremsanlagen oder mit Antriebsschlupfregelung die für die Regelung benötigten Informationen liefern. Bei den herkömmlichen passiven Meßwertaufnehmern oder Radsensoren besteht eine starke Abhängigkeit des Meßsignals von der Raddrehzahl und von dem Luftspalt zwischen dem Meßwertaufnehmer und der Zahnscheibe, die sich mit dem Rad dreht und die Signale im Meßwertgeber durch Induktion hervorruft. Insbesondere bei geringer Drehzahl und bei ungünstigen Fertigungstoleranzen, z.B. bei toleranzbedingt großem Luftspalt, besteht die Gefahr, daß das Nutzsignal von den unvermeidlichen Störsignalen kaum zu trennen ist. Es muß daher bei der Fertigung und bei der Montage ein unerwünscht hoher Aufwand getrieben werden.

Der Erfindung liegt die Aufgabe zugrunde, die Störsicherheit bei der Erfassung der analogen Signale, beispielsweise bei der Erfassung der zuvor beschriebenen Meßsignale mit Radsensoren, zu verbessern und gleichzeitig den Schaltungsaufwand, insbesondere im analogen Signalverarbeitungsbereich, zu verringern. Das Ausgangssignal der zu entwickelnden Schaltungsanordnung sollte mit den derzeitigen Methoden und Schaltungen zur Signalverarbeitung und -auswertung kompatibel sein.

Es hat sich gezeigt, daß diese Aufgabe mit einer Schaltungsanordnung der eingangs genannten Art gelöst werden kann, deren Besonderheit darin besteht, daß ein Regelkreis vorhanden ist, der nach Art eines Deltamodulators aufgebaut ist und einen Komparator aufweist, der das aufzubereitende analoge Signal (x(t)), das die Führungsgröße des Regelkreises ist, mit einem nachgeführten Signal (y(t)) vergleicht, ein die Signaländerung wiedergebendes binäres Signal erzeugt und an eine taktgesteuerte bistabile Kippstufe weiterleitet, daß das Ausgangssignal der bistabilen Kippstufe ein die Differenz zwischen dem aufzubereitenden Signal (x(t)) und dem nachgeführten Signal (y(t)) wiedergebender binärer Datenstrom ist, daß dieser Datenstrom in einem digitalen Akkumulator integriert und über einen D/A-Wandler zum zweiten Eingang des Komparators als nachgeführtes Signal geleitet wird, daß die Integrationszeitkonstante bzw. der im Akkumulator im Integrationstakt jeweils addierte Zahlenwert in Abhängigkeit von dem Ausgangssignal der Kippschaltung variierbar ist, daß das digitale Ausgangssignal des Akkumulators das dem analogen Eingangssignal (x(t)) entsprechende, aufbereitete und A/D - gewandelte analoge Eingangssignal (x(t)) ist.

Der untergeordnete Anspruch 5 bringt zum Ausdruck, daß das digitale Ausgangssignal des ersten Akkumulators mit Hilfe eines digitalen Schwellwertkomparators, der das digitale Ausgangssignal unter Berücksichtigung des Vorzeichens mit dem Mittelwert des Betrages des digitalen Ausgangssignals vergleicht und zur Erzeugung eines aufbereiteten, dem analogen Eingangssignal (x(t)) entsprechenden Rechtecksignals auswertet weiterverarbeitbar ist.

Mit der Schaltungsanordnung gemäß der Erfindung läßt sich ein analoges Signal in ein weiterverarbeitbares digitales Signal umwandeln. Durch den Flankendetektor in Verbindung mit dem nachgeschalteten zweiten Akkumulator wird eine derartige Schaltungsanordnung mit hoher Dynamik erzielt.

Das digitale Ausgangssignal des ersten Akkumulators ist das dem analogen Eingangssignal entsprechende, aufbereitete und A/D-gewandelte Signal.

Nach einer Variante der Erfindung wird also mit Prinzipien und Methoden der digitalen Signalverarbeitung das analoge Eingangssignal verarbeitet. Durch Einsatz eines als Deltamodulator bekannten Regelkreises wird ein digitales Signal erzeugt, das dann mit Hilfe eines Schwellwertkomparators, dem als Schwellwert ein durch Integration gewonnener Mittelwert, nämlich der Mittelwert des gleichgerichteten digitalen Signals, zugeführt wird. Es entsteht schließlich ein Recht ecksignal, das die Frequenz bzw. die Nulldurchgänge des aufbereiteten analogen Eingangssignals wiedergibt. Dieses Rechtecksignal kann dann in herkömmlicher Weise, z.B. mit Hilfe der Auswertungsschaltung eines ABS-Reglers, weiterverarbeitet werden. Die gesamte Schaltung zeichnet sich durch einfachen Aufbau und damit geringe Herstellungskosten und ganz besonders durch eine sichere Trennung von Stör- und Nutzsignalen aus.

Eine Hysterese, die sich an das analoge Eingangssignal anpaßt, wird durch die Schwellwert-bedingte Umschaltung des Schwellwertkomparators erreicht. Diese Umschaltung erfolgt jedesmal dann, wenn das digitale Ausgangssignal den in dem digitalen Integrator gebildeten Mittelwert des digitalen Ausgangssignals überschreitet. Sobald das Ausgangssignal größer als der Mittelwert wird, hat dies ein "Setzen" oder "Rücksetzen" des Schwellwertkomparators, je nach Vorzeichen des Ausgangssignals, und damit ein Signalwechsel am Ausgang des Schwellwertkomparators zur Folge.

Der Mittelwert des Ausgangssignals, der als Schwellwert des Schwellwertkomparators dient, wird zweckmäßigerweise mit Hilfe eines digitalen Integrators gebildet.

Ein zweckmäßiges Ausführungsbeispiel der Erfindung besteht darin, daß das digitale Ausgangssignal über ein digitales Tiefpaßfilter dem Schwellwertkomparator und dem Mittelwertbildner zugeführt wird.

Nach einem weiteren vorteilhaften Ausführungsbeispiel der Erfindung ist ein Flankendetektor vorgesehen, der die Anzahl der aufeinanderfolgenden, gleichwertigen, binären Ausgangssignale der Kippschaltung ermittelt, wobei ein dem Flankendetektor nachgeschalteter zweiter Akkumulator den Zahlenwert zur Anpassung der Integrationskonstante des ersten Akkumulators festlegt. Dieser Zahlenwert liegt zweckmäßigerweise in Abhängigkeit von der Anzahl der aufeinanderfolgenden, gleichwertigen, binären Ausgangssignale der Kippschaltung zwischen 1 und 15. Dies ist der Zahlenwert, den der zweite Akkumulator ermittelt und der im Arbeitstakt jeweils zu dem Inhalt des ersten Akkumulators addiert oder von dem Inhalt subtrahiert wird.

Bei der Schaltungsanordnung dient zweckmäßigerweise der Mittelwert des digitalen Ausgangssignals als Schwellwert des Schwellwertkomparators, wobei dann, wenn der Betrag des digitalen Ausgangssignals größer als der Mittelwert und positiv ist, der Schwellwertkomparator gesetzt und, wenn der Betrag des digitalen Ausgangswertes größer als der Mittelwert und negativ ist, rückgesetzt wird. Solange der Betrag des digitalen Ausgangssignals kleiner als der Mittelwert ist, wobei das Vorzeichen keine Rolle spielt, wird das Ausgangssignal des Komparators nicht geändert.

Weitere Merkmale, Vorteile und Anwendungsmöglichkeiten der Erfindung gehen aus der folgenden Darstellung von Ausführungsbeispielen anhand der beigefügten Abbildungen hervor.

Es zeigen
- Fig. 1: in Blockdarstellung ein Ausführungsbeispiel einer Schaltungsanordnung nach der Erfindung,
- Fig. 2: in gleicher Darstellungsweise wie Fig. 1 ein weiteres Ausführungsbeispiel der Erfindung und
- Fig. 3: Diagramme zur Veranschaulichung der Arbeitsweise der Schaltungsanordnungen nach Fig. 1 und Fig. 2.

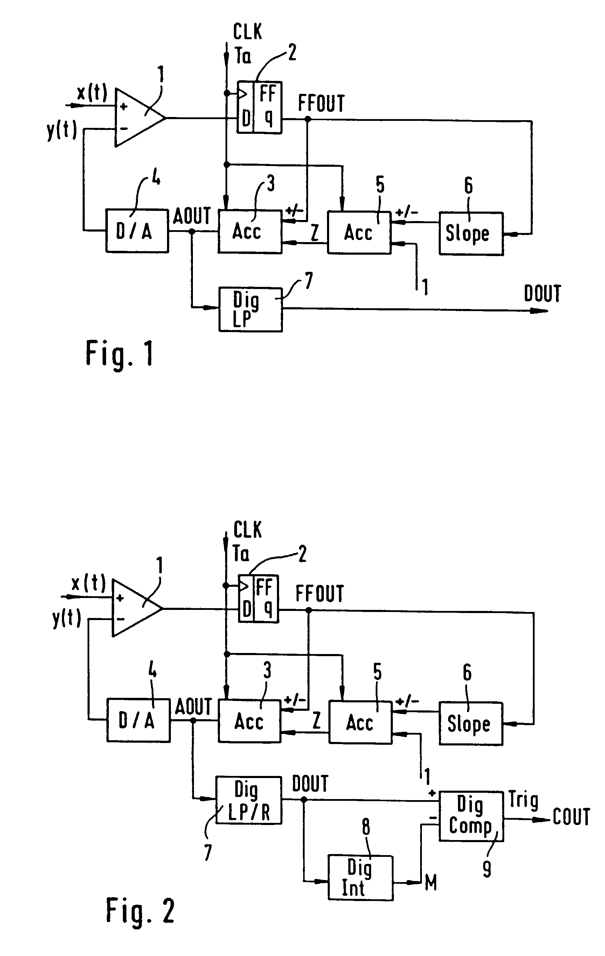

Nach Fig. 1 setzt sich die erfindungsgemäße Schaltungsanordnung im wesentlichen aus einem Komparator 1, einer taktgesteuerten bistabilen Kippschaltung 2, nämlich einem Flip-Flop, einem ersten Akkumulator 3 und einem Digital/Analog-Wandler 4 (D/A-Wandler) sowie aus einem Flankendetektor 6 und einem zweiten Akkumulator 5 zusammen. Das analoge Eingangssignal x(t) liegt an einem der beiden Eingänge des Komparators 1 an. Der Komparator 1, die Kippschaltung 2, der erste Akkumulator 3 und der D/A-Wandler 4 bilden einen Regelkreis nach Art eines Delta-Modulators. "x(t)" ist die Führungsgröße des Regelkreises. "y(t)", das an dem zweiten Eingang des Komparators 1 anliegt, ist das nachgeführte Signal. Der Arbeitstakt CLK für die taktgesteuerte Kippschaltung 2 und für die digitalen Akkumulatoren 3,5 wird dem Regelkreis über den Anschluß CLK zugeführt. Am Ausgang des ersten Akkumulators 3 steht das digitale Ausgangssignal der Schaltungsanordnung zur Verfügung. Es wird zweckmäßigerweise über ein digitales Tiefpaßfilter 7 zur Auswertung weitergeleitet.

Das Ausgangssignal des Komparators 1, der ständig das analoge Eingangssingal x(t) mit dem nachgeführten Signal y(t), das aus dem Ausgangssignal des Akkumulators 3 durch Digital/Analog-Wandlung im D/A-Wandler 4 gewonnen wurde, vergleicht, ist hier ein binäres Signal, dessen Pegel nur von dem Vorzeichen der Differenz zwischen dem analogen Eingangssignal x(t) und dem nachgeführten Signal y(t) abhängt. In der nachgeschalteten Kippstufe 2 wird durch die getaktete Ansteuerung des Flip-Flops ein serieller 1-bit Datenstrom erzeugt, der in dem ersten Akkumulator 3 digital integriert wird. Die Integrationszeitkonstante des Akkumulators 3, die von dem im Arbeitstakt CLK jeweils addierten oder subtrahierten Zahlenwert Z abhängig ist, wird mit Hilfe des Flankendetektors 6 ermittelt, dessen Ausgangssignale in dem zweiten Akkumulator 5 digital integriert werden. Der Flankendetektor 6 erfaßt die Anzahl der aufeinanderfolgenden "gleichwertigen" Ausgangssignale der Kippschaltung 2. Dieser Wert beinhaltet eine Information über die Flankensteilheit des analogen Eingangssignals x(t). Der zweite Akkumulator 5, der ebenfalls ein digitaler Integrator ist, gibt im vorliegenden Ausführungsbeispiel einen Wert Z zwischen 1 und 15 an den ersten Akkumulator 3 ab; dieser Wert Z bestimmt die Integrationszeitkonstante des ersten Akkumulators 3.

Das Ausführungsbeispiel der Erfindung nach Fig. 2 unterscheidet sich von der Schaltungsanordnung nach Fig. 1 durch die weitere Verarbeitung des digitalen Ausgangssignals nach dem Passieren des digitalen Tiefpaßfilters 7. Das gefilterte Ausgangssingal DOUT wird nämlich mit Hilfe eines digitalen Schwellwertkomparators 9 und eines Mittel wertbildners, der ein digitaler Integrator 8 ist, in ein Rechtecksignal COUT gewandelt, welches das Eingangssignal x(t) in aufbereiteter Form darstellt. Die Frequenz dieses Rechtecksignals, abgesehen von Phasenverschiebungen, die vor allem auf die Zeitkontanten der digitalen Filter zurückgehen, entspricht der Frequenz des analogen Eingangssignals x(t).

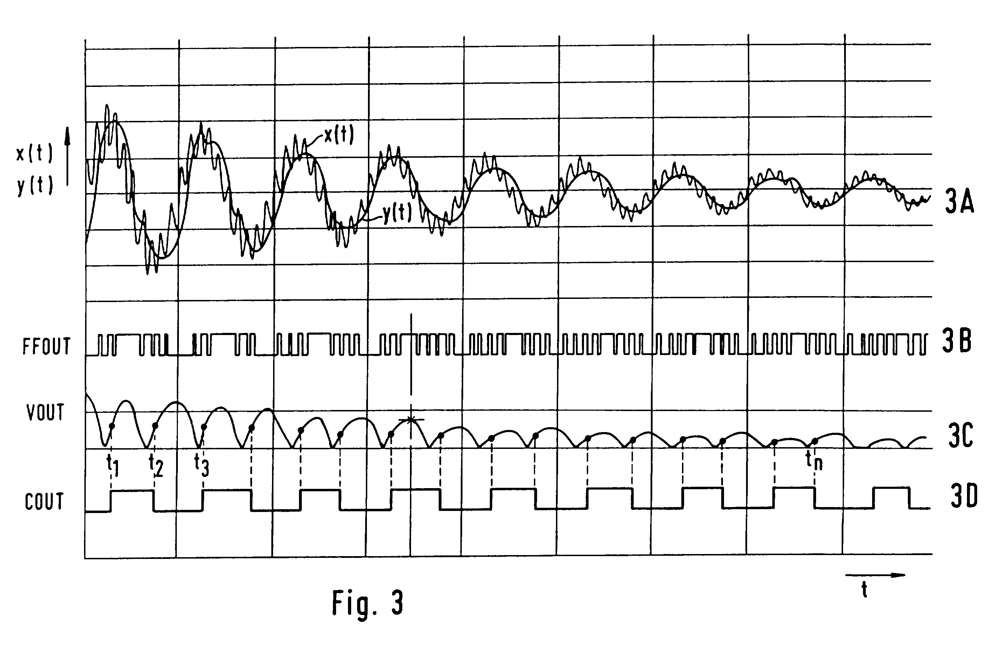

Die Diagramme nach Fig. 3 veranschaulichen die Arbeitsweise der Schaltungsanordnungen nach Fig. 1 und 2. Die obere Kennlinie (Kurve 3A) stellt das verrauschte, mit hochfrequenten Störungen behaftete analoge Eingangssignal x(t) dar. Außerdem ist in Kurve 3A das nachgeführte Signal y(t), das am Ausgang des D/A-Wandlers 3 ansteht, eingetragen. Erkennbar ist das Signal in Kurve 3A durch die auf den Arbeitstakt CLK zurückgehende treppenähnliche Kurve und durch den im Vergleich zum Signal x(t) wesentlich geringeren Anteil an hochfrequenten Störungen.

Kurve 3B zeigt das Ausgangssignal FFOUT der getakteten Kippschaltung 2. Die Anzahl der aufeinanderfolgenden binären Ausgangssignale gleichen Werts oder - wie in Fig. 3B - die Dauer der gleichbleibenden binären Signale enthält die Information über die Flankensteilheit des analogen Eingangssignals.

Die Kurven 3C und 3D in Fig 3 beziehen sich auf die Schaltungsanordnung nach Fig. 2. Kurve 3C ist die analoge Wiedergabe VOUT des digitalen, gleichgerichteten Ausgangssignals am Ausgang DOUT, also am Ausgang des digitalen Tiefpaßfilters 7. In dem Integrator 8 wird der Mittelwert M der Kurve 3C gebildet. Die Mittelwerte, bei deren Errei chen die Umschaltung des Rechteck-Ausgangssignals erfolgt, sind in Kurve 3C durch Punkte markiert. Der Mittelwert dient als Schwelle für den Schwellwertkomparator 9. Zu den Zeitpunkten t₁,t₂...tₙ erreicht der Betrag des digitalen Ausgangswertes DOUT den von dem Integrator 8 ermittelten Mittelwert M. Zu diesen Zeitpunkten t₁,t₂...tₙ wird der Schwellwertkomparator, wie in Fig. 3D dargestellt ist, "gesetzt" bzw. "rückgesetzt". Kurve 3C in Verbindung mit Kurve 3D verdeutlichen die erfindungsgemäß erreichte Anpassung der Hysterese an das analoge Eingangssignal x(t).

Der Mittelwert M wird, wie bereits erläutert, als Schwellwert für den Schwellwertkomparator 9 ausgewertet und legt folglich die Hysterese der erfindungsgemäßen Triggerschaltung und damit den Verlauf des Rechtecksignals am Ausgang der Schaltungsanordnung nach Fig. 2 fest.

## Patentansprüche

1. Schaltungsanordnung zur Aufbereitung und A/D-Wandlung eines analogen Signals, mit einer Triggerschaltung, die das analoge Signal mit einer veränderlichen, sich an das aufzubereitende Signal anpassenden Hysterese verarbeitet, dadurch **gekennzeichnet,**
daß ein Regelkreis (1,2,3,4) vorhanden ist, der ein Deltamodulator ist und einen Komparator (1) aufweist, der das aufzubereitende analoge Signal (x(t)), das die Führungsgröße des Regelkreises ist, mit einem nachgeführten Signal (y(t)) vergleicht, ein die Signaländerung wiedergebendes binäres Signal erzeugt und an eine taktgesteuerte bistabile Kippstufe (Flip-Flop 2) weiterleitet, daß das Ausgangssignal der bistabilen Kippstufe (2) ein die Differenz zwischen dem aufzubereitenden Signal (x(t)) und dem nachgeführten Signal (y(t)) wiedergebender binärer Datenstrom ist, daß ein erster digitaler Akkumulator (3) vorhanden ist, der den Datenstrom integriert und über einen D/A-Wandler (4) zum zweiten Eingang des Komparators (1) als nachgeführtes Signal (y(t)) leitet, und daß die Integrationszeitkonstante bzw. der in dem Akkumulator (3) im Integrationstakt jeweils addierte Zahlenwert (Z) in Abhängigkeit von dem Ausgangssignal (FFOUT) der Kippschaltung (2) variierbar ist, wobei das digitale Ausgangssignal (AOUT) des ersten Akkumulators (3) das dem analogen Eingangssignal (x(t)) entsprechende, aufbereitete und A/D-gewandelte analoge Eingangsignal (x(t)) ist.

2. Schaltungsanordnung nach Anspruch 1, dadurch **gekennzeichnet**, daß das digitale Ausgangssignal (AOUT) des ersten Akkumulators (3) mit Hilfe eines digitalen Tiefpaßfilters (7) weiterverarbeitet wird.

3. Schaltungsanordnung nach Anspruch 1 oder 2, dadurch **gekennzeichnet**, daß ein Flankendetektor (6) vorgesehen ist, der die Anzahl der aufeinanderfolgenden binären Ausgangssignale (FFOUT) der Kippschaltung (2) gleichen Wertes ermittelt, und daß ein dem Flankendetektor nachgeschalteter zweiter Akkumulator (5) den Zahlenwert (Z) zur Anpassung der Integrationskonstante des ersten Akkumulators (3) festlegt.

4. Schaltungsanordnung nach Anspruch 3, dadurch **gekennzeichnet**, daß der erste Akkumulator (3) in Abhängigkeit von der Anzahl der aufeinanderfolgenden binären Ausgangssignale (FF OUT) der Kippschaltung (2) gleichen Werts (und damit von der Flankensteilheit des analogen Signals) im Arbeitstakt (CLK) jeweils einen Wert (Z) zwischen 1 und 15, den der zweite Akkumulator (5) ermittelt, addiert oder subtrahiert.

5. Schaltungsanordnung nach einen oder mehreren der Ansprüche 1 bis 4, dadurch **gekennzeichnet**, daß das digitale Aus gangssignal (AOUT) des ersten Akkumulators (3) mit Hilfe eines digitalen Schwellwertkomparators (9), der das digitale Ausgangssignal (AOUT) unter Berücksichtigung des Vorzeichens mit dem Mittelwert (M) des Betrages (VOUT) des digitalen Ausgangssignals vergleicht und zur Erzeugung eines aufbereiteten, dem analogen Eingangssignal (x(t)) entsprechenden Rechtecksignals auswertet. weiterverarbeitbar ist.

6. Schaltungsanordnung nach Anspruch 5 , dadurch **gekennzeichnet**, daß der Mittelwert des Betrages (VOUT) des digitalen Ausgangssignals (AOUT) als Schwellwert des Schwellwertkomparators (9) ausgewertet wird, wobei, wenn der Betrag des digitalen Ausgangssignals (AOUT) größer als der Mittelwert (M) und positiv ist, der Schwellwertkomparator "gesetzt" wird und, wenn der Betrag größer als der Mittelwert (M), jedoch negativ ist, der Komparator "rückgesetzt" wird.

7. Schaltungsanordnung nach Anspruch 5 oder 6, dadurch **gekennzeichnet**, daß der Mittelwert (M), der als Schwellwert des Schwellwertkomparators (9) dient, mit Hilfe eines digitalen Integrators (9) gebildet wird.

8. Schaltungsanordnung nach einem oder mehreren der Ansprüche 5 bis 7, dadurch **gekennzeichnet**, daß das digitale Ausgangssignal (AOUT) des ersten Akkumulators (3) über ein digitales Tiefpaßfilter (7) dem Schwellenwertkomparator (9)und dem digitalen Integrator (8) zugeführt wird.

## Claims

1. Circuit for conditioning and digitizing an analog signal, including a trigger circuit which processes the analog signal by way of a variable hysteresis that adapts to the signal to be conditioned,
**characterized** in that a control circuit (1,2,3,4) is provided as a delta modulator and has a comparator (1) which compares the analog signal (x(t)) to be conditioned, which is the reference input of the control circuit, with an adapted signal (y(t)), produces a binary signal representative of the signal variation and conducts it to a clock-controlled bistable flip-flop (2), in that the output signal of the bistable flip-flop (2) is a binary data stream representative of the difference between the signal (x(t)) to be conditioned and the adapted signal (y(t)), in that a first digital accumulator (3) is provided to integrate the data stream and to conduct it, by way of a digitizer (4), as an adapted signal (y(t)) to the second input of the comparator (1), and in that the integration time constant or the numerical value (Z) that is respectively added in the accumulator (3) in the integration cycle is variable as a function of the output signal (FFOUT) of the flip-flop (2), and the digital output signal (AOUT) of the first accumulator (3) is the conditioned and digitized analog input signal (x(t)) corresponding to the analog input signal (x(t)).

2. Circuit as claimed in claim 1,
**characterized** in that the digital output signal (AOUT) of the first accumulator (3) is processed further by way of a digital low-pass filter (7).

3. Circuit as claimed in claim 1 or claim 2,
**characterized** in that an edge detector (6) determines the number of the successive binary output signals (FFOUT) of the flip-flop (2) of identical value, and in that a second accumulator (5) connected downstream of the edge detector fixes the numerical value (Z) for adapting the integration constant of the first accumulator (3).

4. Circuit as claimed in claim 3,
**characterized** in that the first accumulator (3) in each case adds or substracts a value (Z) between 1 and 15, determined by the second accumulator (5), as a function of the number of the successive binary output signals (FF OUT) of the flip-flop (2) of identical value (and thus as a function of the edge steepness of the analog signal) in the working cycle (CLK).

5. Circuit as claimed in any one or more of claims 1 to 4,
**characterized** in that the digital output signal (AOUT) of the first accumulator (3) can be processed further by way of a digital threshold value comparator (9) which compares the digital output signal (AOUT), in consideration of the sign, with the mean value (M) of the quantity (VOUT) of the digital ouput signal and evaluates it to generate a conditioned square wave signal which corresponds to the analog input signal (x(t)).

6. Circuit as claimed in claim 5,
**characterized** in that the mean value of the quantity (VOUT) of the digital output signal (AOUT) is evaluated as a threshold value of the threshold value comparator (9), and the threshold value comparator is "set" when the quantity of the digital output signal (AOUT) is in excess of the mean value (M) and positive, and the comparator is "reset" when the quantity is in excess of the mean value (M) but negative.

7. Circuit as claimed in claim 5 or 6,
**characterized** in that the mean value (M), which serves as a threshold value of threshold value comparator (9), is produced by way of a digital integrator (8).

8. Circuit as claimed in any one or more of claims 5 to 7,
**characterized** in that the digital output signal (AOUT) of the first accumulator (3) is sent to the threshold value comparator (9) and the digital integrator (8) by way of a digital low-pass filter (7).

## Revendications

1. Agencement de circuit pour la mise en forme et la conversion analogique/numérique d'un signal analogique, comprenant un circuit de déclenchement qui traite le signal analogique avec une hystérésis variable s'adaptant au signal à mettre en forme, caractérisé en ce qu'il est prévu un circuit de régulation (1, 2, 3, 4) qui est un modulateur delta et comprend un comparateur (1) qui compare le signal analogique à mettre en forme (x(t)), qui est la grandeur de référence du circuit de régulation, à un signal auxiliaire (y(t)), produit un signal binaire reproduisant la variation de signal et le transmet à une bascule bistable à commande impulsionnelle (flip-flop 2), en ce que le signal de sortie de la bascule bistable (2) est un flux de données binaires reproduisant la différence entre le signal à mettre en forme (x(t)) et le signal auxiliaire (y(t)), en ce qu'il est prévu un premier accumulateur numérique (3) qui intègre le flux de données et le transmet, par l'intermédiaire d'un convertisseur numérique/analogique (4), à la seconde entrée du comparateur (1) en tant que signal auxiliaire (y(t)) et en ce que la constante de temps d'intégration ou la valeur numérique (Z) chaque fois ajoutée dans l'accumulateur (3) suivant la cadence impulsionnelle d'intégration peut être soumise à une variation en fonction du signal de sortir (FFOUT) de la bascule (2), le signal numérique de sortie (AOUT) du premier accumulateur (3) étant le signal analogique d'entrée (x(t)) mis forme et ayant été soumis à la conversion analogique/numérique qui correspond au signal analogique d'entrée (x(t)).

2. Agencement de circuit suivant la revendication 1, caractérisé en ce que le signal numérique de sortie (AOUT) du premier accumulateur (3) fait l'objet d'un traitement supplémentaire au moyen d'un filtre passe-bas numérique (7).

3. Agencement de circuit suivant la revendication 1 ou 2, caractérisé en ce qu'il est prévu un détecteur de flancs (6) qui détermine le nombre des signaux binaires de sortie successifs (FFOUT) de la bascule (2) ayant la même valeur et en ce qu'un second accumulateur (5) disposé en aval du détecteur de flancs établit la valeur numérique (Z) servant à l'adaptation de la constante d'intégration du premier accumulateur (3).

4. Agencement de circuit suivant la revendication 3, caractérisé en ce qu'en fonction du nombre des signaux binaires successifs de sortie (FFOUT) de la bascule (2) qui ont la même valeur (et donc de la pente du signal analogique), le premier accumulateur (3) ajoute ou soustrait chaque fois, à la cadence impulsionnelle de travail (CLK), une valeur (Z) comprise entre 1 et 15 que détermine le second accumulateur (5).

5. Agencement de circuit suivant une ou plusieurs des revendications 1 à 4, caractérisé en ce que le signal numérique de sortie (AOUT) du premier accumulateur (3) peut être ensuite traité au moyen d'un comparateur numérique à valeur de seuil (9) qui, en tenant compte du signe, compare le signal numérique de sortie (AOUT) à la valeur moyenne (M) de l'amplitude (VOUT) du signal numérique de sortie et l'exploite pour produire un signal rectangulaire mis en forme correspondant au signal analogique d'entrée (x(t)).

6. Agencement de circuit suivant la revendication 5, caractérisé en ce que la valeur moyenne de la valeur (VOUT) du signal numérique de sortie (AOUT) est exploitée en tant que valeur de seuil du comparateur à valeur de seuil (9), le comparateur à valeur de seuil faisant l'objet d'un "changement d'état" lorsque la valeur du signal numérique de sortie (AOUT) est supérieure à la valeur moyenne (M) et positive et le comparateur faisant l'objet d'une "remise à l'état initial" lorsque la valeur est supérieure à la valeur moyenne (M), mais est négative.

7. Agencement de circuit suivant la revendication 5 ou 6, caractérisé en ce que la valeur moyenne (M) qui sert de valeur de seuil du comparateur à valeur de seuil (9) est formée au moyen d'un intégrateur numérique (8).

8. Agencement de circuit suivant une ou plusieurs des revendications 5 à 7, caractérisé en ce que le signal numérique de sortie (AOUT) du premier accumulateur (3) est envoyé au comparateur à valeur de seuil (9) et à l'intégrateur numérique (8) par l'intermédiaire d'un filtre passe-bas numérique (7).
